(19) Europäisches Patentamt / European Patent Office / Office européen des brevets

(11) **EP 2 254 066 A1**

(12) **DEMANDE DE BREVET EUROPEEN**

(43) Date de publication:
**24.11.2010 Bulletin 2010/47**

(51) Int Cl.:
***G06F 17/50*** *(2006.01)*     ***G06F 9/00*** *(2006.01)*

(21) Numéro de dépôt: **10161728.0**

(22) Date de dépôt: **03.05.2010**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**
Etats d'extension désignés:
**BA ME RS**

(30) Priorité: **18.05.2009 FR 0953267**

(71) Demandeur: **Airbus Operations (Société par actions simplifiée)**
**31060 Toulouse (FR)**

(72) Inventeur: **Minot, Frédéric**
**31810 Venerque (FR)**

(74) Mandataire: **Augarde, Eric et al**
**BREVALEX**
**56 Boulevard de l'Embouchure,**
**Bât. B**
**B.P. 27519**
**31075 Toulouse Cedex 2 (FR)**

(54) **Méthode d'aide à la réalisation et de validation d'une plateforme avionique**

(57) L'invention concerne une méthode d'aide à la réalisation et de validation d'une plateforme avionique. Elle utilise, d'une part, une description fonctionnelle de la plateforme à l'aide de fonctions avioniques, de modules logiciel adaptés à exécuter ces fonctions et d'occurrences de lien fonctionnel entre ces modules et, d'autre part, une description matérielle de cette plateforme à l'aide d'équipements de calcul ou de communication ainsi que de liaisons physiques entre ces équipements. La méthode selon l'invention permet de générer des chemins entre les différents équipements en utilisant soit des liaisons physiques directes et/ou des liaisons physiques appartenant à un ou plusieurs réseau(x), puis d'associer à chaque occurrence de lien fonctionnel au moins un tel chemin. Elle permet également d'associer à chaque module logiciel un équipement destiné à l'héberger.

**Fig. 4**

**Description**

## DOMAINE TECHNIQUE

La présente invention concerne de manière générale le domaine des plateformes avioniques et plus précisément celles qui sont réalisées selon une architecture modulaire intégrée, dite IMA (*Integrated Modular Avionics*).

## ÉTAT DE LA TECHNIQUE ANTÉRIEURE

La réalisation d'une plateforme avionique, c'est-à-dire de l'ensemble des moyens de calcul et de communication embarqués permettant d'exécuter les fonctions d'un aéronef fait traditionnellement appel à des calculateurs et des bus de communication dédiés. Dans une telle plateforme, chaque fonction de l'aéronef, dénommée ci-après fonction avionique, est implémentée à l'aide de calculateurs ayant une architecture et des entrées-sorties spécifiques à la réalisation de la fonction. Ceci implique de réaliser, certifier et maintenir un grand nombre de composants ou LRUs (*Line Replaceable Units*), et ce à chaque fois qu'un nouveau type d'appareil doit être conçu.

Pour remédier à cette source de complexité et de coûts, les plateformes avioniques de nouvelle génération utilisent, autant que faire se peut, une architecture modulaire intégrée (IMA). Dans ce type d'architecture, les fonctions avioniques sont implémentées dans des ressources partagées, en pratique sous forme de modules logiciel hébergés par des calculateurs génériques, et utilisant des moyens de communication non dédiés. Une telle plateforme présente de nombreux avantages en termes de réduction de la quantité de calculateurs, du nombre de types différents de calculateurs, de nombre de câbles, etc., ce qui se traduit en définitive par un bilan de masse plus favorable et d'importants gains en matière de maintenance et de gestion des stocks.

Toutefois, alors que les plateformes avioniques traditionnelles étaient réalisées de manière empirique, à l'aide de règles fondées sur l'expérience et en procédant par de nombreux allers-retours entre phase de conception et phase de validation, les plateformes de nouvelle génération requièrent une approche entièrement différente, tant en raison de leur complexité que du partage de ressources entre fonctions avioniques, inhérent à l'architecture IMA. Par exemple, alors que les défaillances matérielles concomitantes d'équipements fonctionnels étaient autrefois évitées en utilisant des ressources de calcul et de communication dédiées, l'architecture IMA ne permet pas de garantir cette robustesse de manière intrinsèque. Il est donc nécessaire de répartir judicieusement les modules logiciel dans les calculateurs génériques et de s'assurer que les moyens de communication permettent d'assurer les échanges entre ces modules.

Réciproquement, pour une plateforme donnée, il est important de vérifier que l'ensemble des fonctions avioniques initialement prévues sont implémentées correctement.

Un premier but de la présente invention est par conséquent de fournir une méthode et un outil d'aide à la réalisation d'une plateforme avionique selon une architecture modulaire intégrée.

Un second but de la présente invention est de proposer une méthode de validation de l'implémentation d'un ensemble de fonctions avioniques par une plateforme donnée.

## EXPOSÉ DE L'INVENTION

La présente invention est définie par une méthode d'aide à la réalisation d'une plate-forme avionique destinée à implémenter un ensemble de fonctions avioniques, chaque fonction avionique (Function) comprenant un ou plusieurs modules logiciel (SystemFunctionOc), deux modules logiciel quelconques pouvant échanger des messages au moyen d'un lien (FctLinkOc), dit occurrence de lien fonctionnel, ladite plateforme avionique comprenant par ailleurs des équipements (EquipmentOc) reliés entre eux par des liaisons physiques (PhysicalLink) unidirectionnelles ou bidirectionnelles appartenant à différents types de réseau, des chemins (Path) permettant de relier lesdits équipements, chaque chemin étant constitué soit par une seule liaison physique directe entre un équipement source et un équipement destinataire, soit par une première liaison physique entre ledit équipement source et un premier noeud de réseau, une seconde liaison physique entre ledit équipement destinataire et un second noeud de réseau et au moins une troisième liaison physique entre lesdits premier et second noeuds (NetPath). Selon cette méthode, on associe à chaque module logiciel un équipement sur lequel il est destiné à être hébergé et à chaque occurrence de lien fonctionnel au moins un chemin destiné à faire transiter les messages de ce lien et, l'on vérifie pour chaque équipement (m) s'il dispose de ressources matérielles ($\beta_m(\alpha_j)$) suffisantes pour permettre l'exécution du module ou des modules logiciel qui lui est (sont) associé(s).

Pour chaque équipement, on peut vérifier en outre si les ressources de connexion (CnxResource) de ses connecteurs sont suffisantes pour accueillir les chemins (Path) associés aux liens fonctionnels des modules logiciel qui lui sont associés.

Les liaisons physiques peuvent être d'un premier type ($1 \Rightarrow 1$) permettant de relier de manière unidirectionnelle un équipement à un seul autre équipement, ou bien d'un second type ($1 \Rightarrow N$) permettant de relier de manière unidirectionnelle un équipement à une pluralité d'autres équipements, d'un troisième type ($1 \Leftrightarrow 1$) permettant de relier de manière bidirectionnelle deux équipements, ou encore d'un quatrième type ($N \Leftrightarrow N$) permettant de relier de manière bidirectionnelle une pluralité d'équipements.

Avantageusement, on associe à chaque connecteur d'un équipement des ressources de connexion (CnxResource), chaque ressource de connexion étant capable de recevoir une liaison physique (PhysicalLink) du premier, second, troisième ou bien quatrième type.

De préférence, pour chaque équipement source, on liste les types des liaisons physiques associées aux ressources de connexion des connecteurs de cet équipement, on sélectionne un type de liaison parmi les types de liaisons ainsi listés, puis on liste les équipements possédant des ressources de connexion capables de recevoir le type de liaison ainsi sélectionné et l'on sélectionne un équipement destinataire parmi les équipements ainsi listés.

On peut générer un chemin entre l'équipement source et l'équipement destinataire en créant une nouvelle liaison physique du dit type sélectionné entre ces deux équipements, si celui-ci est le premier ou le troisième type, le chemin généré étant alors associé à la liaison physique ainsi créée et étant unidirectionnelle dans le cas du premier type et bidirectionnelle dans le cas du troisième type.

On peut alternativement générer un chemin entre l'équipement source et l'équipement destinataire en l'associant à une liaison physique existante ou en créant une nouvelle liaison du dit type sélectionné entre ces deux équipements, si ledit type sélectionné est le deuxième ou le quatrième type, le chemin généré étant alors associé à la liaison existante ou créée et étant unidirectionnelle dans le cas du deuxième type et bidirectionnelle dans le cas du quatrième type.

On vérifie avantageusement si les ressources de connexion des connecteurs de l'équipement source d'une part et celles des connecteurs de l'équipement destinataire, d'autre part, sont suffisantes pour accueillir les nouvelles liaisons physiques créées, le chemin généré étant validé dans l'affirmative et invalidé dans la négative.

L'invention concerne également un outil d'aide à la réalisation d'une plateforme avionique comprenant une première base de données dans laquelle est stockée une description fonctionnelle de ladite plate-forme, une seconde base de données dans laquelle est stockée une description matérielle de ladite plate-forme, une station de travail reliée aux première et seconde bases de données, ladite station de travail comprenant des moyens adaptés à mettre en oeuvre les étapes de la méthode exposée ci-dessus.

La description fonctionnelle comprend, de préférence, une liste des fonctions avioniques et des liens entre elles, une liste des modules logiciel permettant d'exécuter les fonctions avioniques et des occurrences de lien fonctionnel entre ces modules. De manière similaire la description matérielle comprend une liste d'équipements de calcul ou de communication ainsi qu'une liste des liaisons physiques entre ces équipements.

## BRÈVE DESCRIPTION DES DESSINS

D'autres caractéristiques et avantages de l'invention apparaîtront à la lecture de modes de réalisation préférentiels de l'invention en référence aux figures jointes parmi lesquelles :

La Fig. 1 donne une représentation schématique orientée objet des fonctions avioniques d'un aéronef ;
La Fig. 2 donne une représentation schématique orientée objet d'une plateforme avionique ;
Les Figs. 3A à 3C illustrent des exemples de liaisons physiques, liens topologiques, chemins réseau et chemins topologiques dans une plateforme avionique ;
La Fig. 4 illustre schématiquement la correspondance entre les fonctions avioniques et les éléments de la plateforme avionique, utilisée dans un mode de réalisation de l'invention ;
La Fig. 5 illustre schématiquement un outil d'aide à la réalisation de plateforme avionique selon un mode de réalisation de l'invention ;
La Fig. 6 est une représentation complémentaire orientée objet des besoins en ressources matérielles des fonctions avioniques ainsi que des quantités de ressources matérielles offertes pas les équipements de la plateforme avionique ;
La Fig. 7 représente schématiquement la génération de certains enregistrements dans la base de données matérielle de la Fig. 5.

## EXPOSÉ DÉTAILLÉ DE MODES DE RÉALISATION PARTICULIERS

Nous considérerons dans la suite une plateforme avionique à réaliser selon une architecture modulaire intégrée, telle que définie précédemment. Cette plateforme est destinée à mettre en oeuvre un ensemble de fonctions avioniques prédéterminées. A titre d'exemple, ces fonctions avioniques peuvent être le contrôle du roulis de l'avion, le calcul de la quantité de carburant, etc.

A chacune de ces fonctions avioniques, on associe en règle générale une pluralité de modules logiciel qui sont destinés à être hébergés dans des calculateurs génériques embarqués et dont chacun participe à la réalisation de la fonction. Pour des raisons de sûreté, certaines fonctions peuvent être dupliquées. Les modules logiciel de fonctions dupliquées ne sont pas nécessairement identiques. Par exemple, deux tels modules logiciel peuvent correspondre à une voie de commande (COM) et une voie de surveillance (MON) d'un système de contrôle de vol et utiliser des algorithmes différents pour réaliser la même fonction.

Les modules logiciel associés aux différentes fonctions avioniques peuvent échanger des messages entre eux via des liens, dénommés « occurrences de lien fonctionnel » comme nous le verrons ci-après. Par exemple, un module logiciel réalisant la fonction de contrôle de roulis peut transmettre un message d'alerte à un module logiciel en charge de la fonction d'affichage.

L'ensemble des fonctions avioniques d'un aéronef ainsi que leurs relations entre elles peuvent avantageusement être représentées à l'aide d'une modélisation objet.

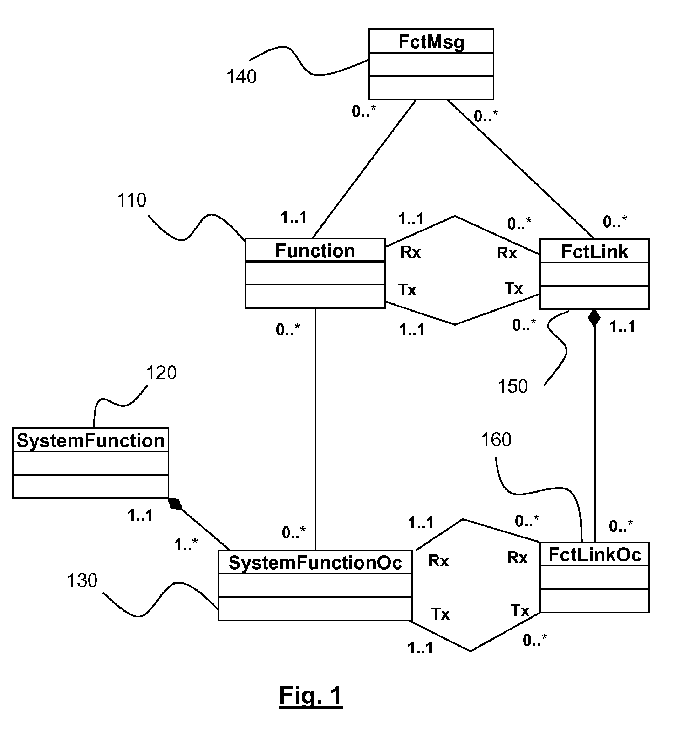

La Fig. 1 donne un diagramme UML (*Unified Modeling Language*) modélisant la structure de données et les relations entre fonctions avioniques d'un aéronef. On trouvera par exemple une description du langage UML dans l'ouvrage de F. Barbier intitulé « UML2 et MDE » publié chez Dunod.

Le modèle représenté comprend les objets (ou classes) dénommés « Function », « SystemFunction », « SystemFunctionOc », « FctMsg », « FctLink » et « FctLinkOc ». Pour des raisons de simplification, les attributs et les méthodes relatifs aux différents objets ont été omis là où ils n'apparaissaient pas nécessaires à la bonne compréhension de l'invention.

L'objet « Function », 110, correspond à une fonction avionique. Cet objet est associé avec une multiplicité quelconque à des objets « SystemFunctionOc », 130, explicités ci-après. Une fonction peut transmettre un nombre quelconque de messages, au moyen d'un lien symbolique, dénommé lien fonctionnel, à une autre fonction. Ainsi, l'objet « Function », 110, est associé à 0 à N objets « Fctmsg », 140. Chaque lien fonctionnel, modélisé par l'objet « FctLink », 150, est associé à une fonction avionique émettrice et une fonction avionique destinataire. Réciproquement, à une fonction peuvent être associés un nombre quelconque de liens entrants ainsi qu'un nombre quelconque de liens sortants. En outre, un lien fonctionnel peut voir transiter un nombre quelconque de messages et, réciproquement, un message d'une fonction avionique peut être transmis sur un nombre quelconque de liens fonctionnels.

Chaque lien fonctionnel 150, est instanciable et composé de 0 à N d'occurrences de lien fonctionnel, 160. Les occurrences de lien fonctionnel désignés par l'objet « FctLinkOc »

L'objet « SystemFunction », désigné par 120, est composé d'au moins une occurrence « SystemFunctionOc », 130. L'objet 130 peut être considéré en pratique comme un module logiciel destiné à être hébergé par un équipement, l'objet 120 représentant alors une classe de tels modules logiciels. L'objet 130 est associé à un nombre quelconque d'occurrences de liens fonctionnel entrant ainsi qu'à un nombre quelconque de lien fonctionnel sortant. Réciproquement, une occurrence de lien fonctionnel est associée à un module logiciel émetteur et un module logiciel destinataire.

Le modèle représenté en Fig. 1 permet de stocker avantageusement la représentation fonctionnelle de plate-forme avionique dans une première base de données, dénommée ci-après base de données fonctionnelle.

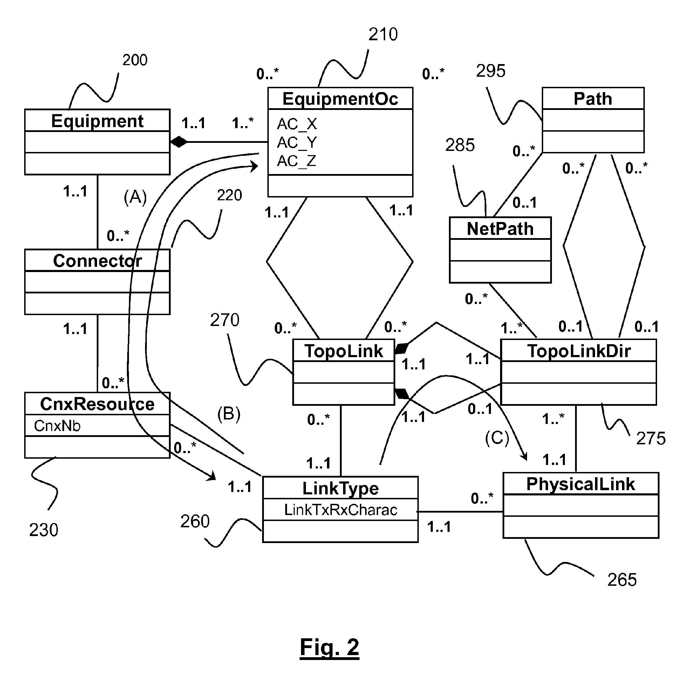

La méthode selon l'invention utilise en outre une représentation matérielle de la plateforme avionique. La Fig. 2 donne, sous forme d'un diagramme UML, la structure de données de cette représentation.

Dans le cadre de la présente invention, la structure matérielle d'une plateforme avionique est généralement décrite à l'aide d'objets dénommés « Equipement », « EquipementOc », « Connector », « CnxResource », « LinkType », « TopoLink », « TopoLinkDir », « NetPath », « Path », « Physical Link » définis ci-après.

La brique de base de cette structure matérielle est l'objet « Equipment », 200, lui-même composé par une ou des occurrence(s) d'équipement, 210. Concrètement, l'objet « Equipment » représente une classe constituée d'éléments matériels tels que des calculateurs, des capteurs, des actuateurs, des commutateurs, des routeurs, des passerelles etc. Un équipement peut être plus généralement considéré comme un élément matériel disposant de ressources de calcul et/ou de communication. Chaque objet « Equipement » peut comprendre un ou plusieurs connecteurs, représentés par l'objet 220, eux-mêmes constitués d'un nombre quelconque de ressources de connexion, représentées par l'objet 230. Ces ressources sont en pratique des ports physiques sur lesquels peuvent venir se connecter des liens physiques.

Chaque occurrence d'équipement, 210, hérite des attributs de l'objet « Equipment » notamment des ressources matérielles, comme nous le verrons plus loin. Il est en outre caractérisé par des attributs propres, notamment sa position dans l'avion, donnée ici en coordonnées cartésiennes.

On introduit également l'objet « LinkType », 260, destiné à représenter le type de liaison physique d'un support de communication. Cet objet a pour attribut une caractéristique « LinkTxRxChar » donnant la capacité de ladite liaison à relier des équipements entre eux. Plus précisément, cette caractéristique peut prendre les valeurs suivantes :

$1 \Rightarrow 1$ : liaison directionnelle pouvant relier une occurrence d'équipement émettrice à une seule occurrence d'équipement réceptrice ;

$1 \Rightarrow N$ : liaison directionnelle pouvant relier une occurrence d'équipement émettrice à une pluralité d'occurrences d'équipements réceptrices ;

$1 \Leftrightarrow 1$ : liaison bidirectionnelle pouvant relier une occurrence d'équipement à une seule autre occurrence

d'équipement ;

$N \Leftrightarrow N$ : liaison bidirectionnelle pouvant relier plusieurs occurrences d'équipements entre eux, dans les deux sens.

Par exemple, une liaison physique d'un réseau AFDX (*Avionics Full DupleX*) est de type $1 \Leftrightarrow 1$ (même si un lien virtuel multicast permet de relier un terminal à une pluralité d'autres terminaux), un bus CAN (*Controller Area Network*) est de type $N \Leftrightarrow N$, une liaison d'un réseau ARINC 429 est de type $1 \Rightarrow N$, un câble destiné à relier une sortie numérique (resp. analogique) d'un équipement à une pluralité d'entrées numériques (resp. analogiques) d'équipement est également de type $1 \Rightarrow N$. Selon sa caractéristique, un type de liaison pourra être associé à une ou plusieurs ressources de communication, 230, d'un connecteur, 220, appartenant à un équipement, 210, voire à aucune ressource de communication si le type de liaison n'est pas supporté par cet équipement.

L'objet « PhysicalLink », 265, représente les liaisons physiques, indépendamment du réseau auquel elles appartiennent éventuellement. A chaque liaison physique est associé un type de liaison unique tel que défini plus haut.

L'objet « TopoLink » ou lien topologique, 270, est une entité abstraite indiquant la possibilité de connecter deux occurrences d'équipement au moyen d'une liaison physique, de manière unidirectionnelle ou bidirectionnelle. A partir de cet objet on définit un lien topologique orienté, soit « TopoLinkDir », 275, chaque lien topologique étant composé soit d'un, soit de deux liens topologiques orientés.

On définit encore l'objet de chemin réseau « NetPath », 285, comme une liste ordonnée et connexe de liens topologiques orientés entre des noeuds de réseau de communication. Il est important de souligner que les liens physiques sous-jacents à ces liens topologiques orientés n'appartiennent pas nécessairement à un même réseau. Un chemin réseau comprend au moins un lien topologique et, inversement, un lien topologique orienté peut faire partie d'un nombre quelconque de chemins réseau, voire d'aucun chemin réseau si ce lien est isolé.

Enfin on définit un objet plus général, dit « Path » ou chemin topologique, 295, pouvant relier deux occurrences quelconques d'équipement de la plateforme avionique. Un tel chemin est constitué soit d'un lien topologique orienté dans l'un ou l'autre sens (autrement dit, les occurrences d'équipement sont reliées par une simple liaison physique), soit d'un chemin réseau auquel est adjoint, à l'une ou ses deux extrémité(s), un lien topologique orienté.

Le modèle représenté en Fig. 2 permet de stocker la représentation matérielle de plateforme avionique dans une seconde base de données, dénommée ci-après base de données matérielle.

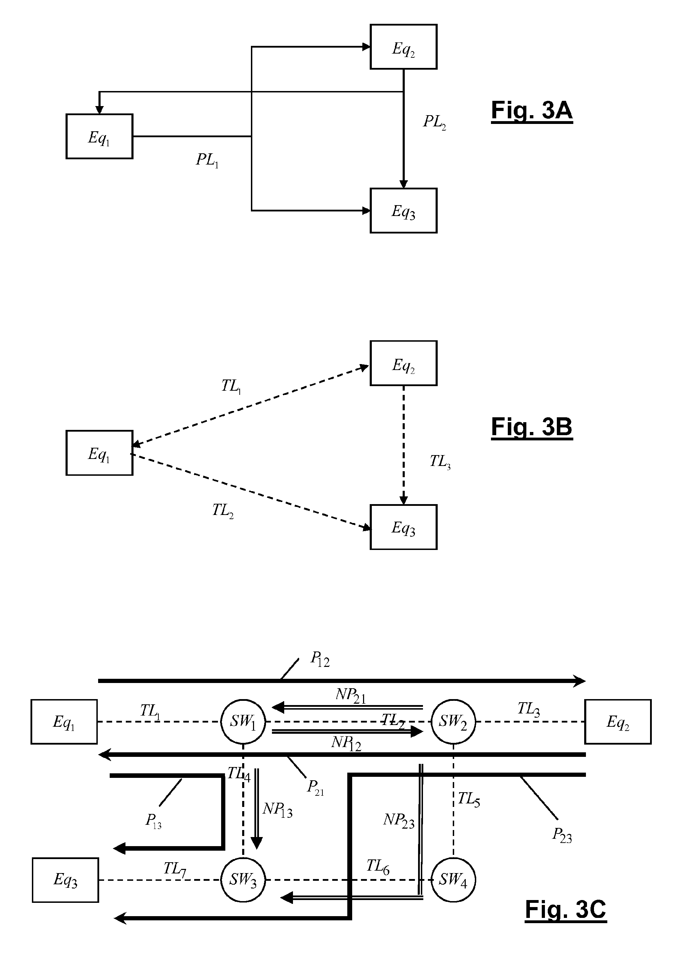

A titre d'illustration, nous avons donné en Figs. 3A à 3C des exemples de liaisons physiques, de liens topologiques, de chemins réseau et de chemins topologiques entre différents équipements.

On a représenté sur ces figures trois équipements (plus rigoureusement, selon la terminologie objet, trois occurrences d'équipement) $Eq_1, Eq_2, Eq_3$.

En Fig. 3A, l'équipement $Eq_1$ est relié aux équipements $Eq_2, Eq_3$ à l'aide d'une première liaison physique $PL1$ de type $1 \Rightarrow N$. De même, l'équipement $Eq_2$ est relié aux équipements $Eq_1, Eq_3$, à l'aide d'une seconde liaison physique $PL_2$ également de type $1 \Rightarrow N$.

La Fig. 3B représente les liens topologiques $TL_1$, $TL_2$, $TL_3$ associés aux liaisons physiques de la Fig. 3A. Plus précisément, le lien topologique $TL_1$ entre les équipements $Eq_1$ et $Eq_2$ est associé aux liaisons physiques $PL_1$ et $PL_2$ entre ces deux équipements. Le lien topologique $TL_1$ est en fait composé d'un premier lien topologique orienté entre $Eq_1$ et $Eq_2$ et d'un second lien topologique orienté, de sens inverse. Les liens topologiques $TL_2$ et $TL_3$ sont respectivement associés aux liaisons physiques $PL_1$ et $PL_2$. Ils sont constitués chacun d'un seul lien topologique orienté.

La Fig. 3C représente trois équipements $Eq_1, Eq_2, Eq_3$ reliés à l'aide d'un réseau AFDX comprenant quatre commutateurs $SW_1, ..., SW_4$. On a désigné par $TL_1$ à $TL_7$ les différents liens topologiques bidirectionnels (liaisons physiques sous-jacentes de type $1 \Leftrightarrow 1$), chaque lien topologique $TL_i$ étant constitué de deux liens topologiques orientés $TL_i^+$ et $TL_i^-$ (le sens positif a été conventionnellement choisi ici comme le sens horaire). On a également indiqué les chemins réseau $NP_{12}$ $NP_{21}$, $NP_{13}$, $NP_{23}$, définis respectivement par $NP_{12} = \left\{ TL_2^+ \right\}$ ; $NP_{21} = \left\{ TL_2^- \right\}$ ; $NP_{13} = \left\{ TL_4^+ \right\}$ ; $NP_{23} = \left\{ TL_5^+, TL_6^+ \right\}$. Le chemin topologique $P_{12}$ qui relie l'équipement $Eq_1$ à l'équipement $Eq_2$ est alors constitué par $P_{12} = \left\{ TL_1^+, NP_{12}, TL_3^+ \right\}$. De manière similaire, le chemin topologique $P_{21}$ qui relie l'équipement $Eq_2$ à l'équipement $Eq_1$ est constitué par $P_{21} = \left\{ TL_3^-, NP_{21}, TL_1^- \right\}$. Le chemin topologique $P_{13}$, reliant l'équipement $Eq_1$ à $Eq_3$, et celui $P_{23}$ reliant l'équipement $Eq_2$ à $Eq_3$ sont respectivement constitués par $P_{13} = \left\{ TL_1^+, NP_{13}, TL_7^+ \right\}$ et $P_{23} = \left\{ TL_3^-, NP_{23}, TL_7^+ \right\}$.

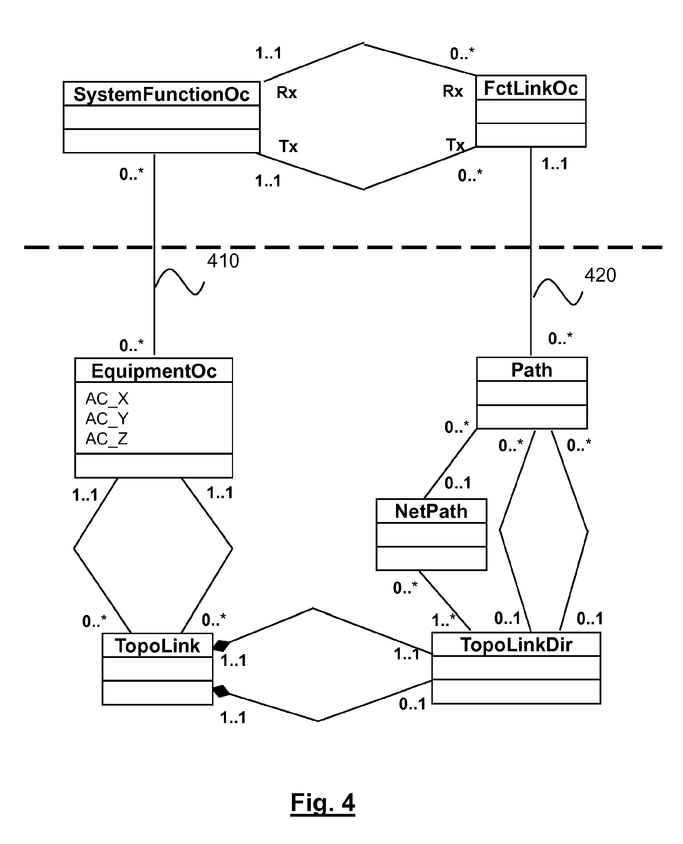

La Fig. 4 représente de manière schématique l'implémentation des fonctions avioniques sur la plateforme avionique.

On retrouve sur cette figure une partie du modèle de la structure fonctionnelle de la plateforme et une partie du modèle de sa structure matérielle, séparée schématiquement par un trait discontinu. La réalisation de la plateforme consiste à associer d'une part chaque objet « SystemFunctionOc » c'est-à-dire à chaque module logiciel d'une fonction avionique, une occurrence d'équipement « EquipmentOc » destinée à l'héberger et, d'autre part, à tout lien fonctionnel « FctLinkOc » un ou plusieurs chemin(s) destiné(s) à faire transiter les messages fonctionnels entre les modules logiciel relatifs aux fonctions avioniques.

Cette opération d'association se traduit dans le diagramme par les relations d'association 410 et 420.

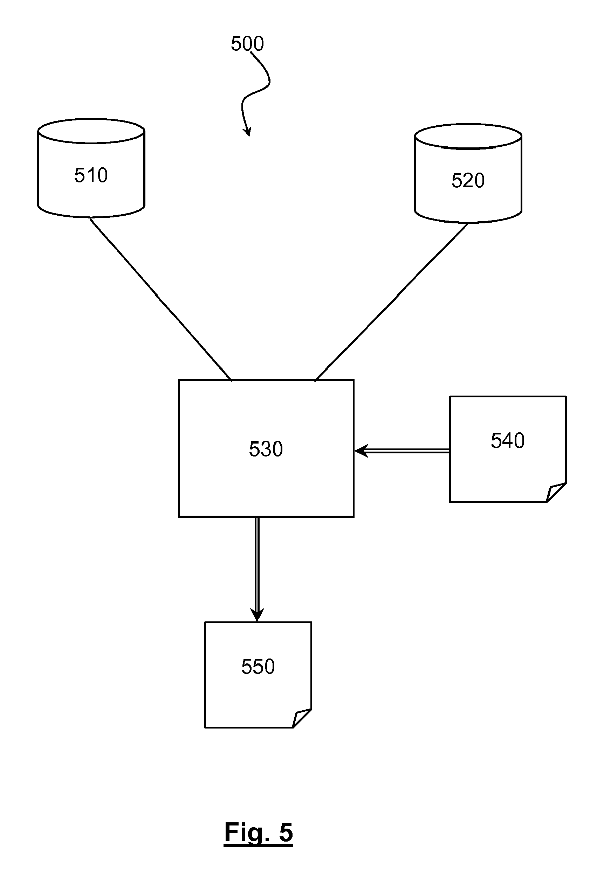

La Fig. 5 représente de manière schématique un outil d'aide à la réalisation de plateforme avionique selon un mode de réalisation de l'invention.

L'outil en question, 500, comprend d'une part la base de données fonctionnelle, 510, la base de données matérielle, 520, une station de travail 530 et le cas échéant, un fichier de contraintes 540. Le fichier de contraintes a pour but de spécifier certaines contraintes de routage des liens fonctionnels dans la plateforme, autrement dit d'interdire ou d'imposer certains chemins topologiques. La station de travail permet d'effectuer l'opération d'association précitée et fournit en sortie un fichier d'implémentation, 550, attribuant à chaque module logiciel l'occurrence d'équipement (le calculateur) qui l'hébergera et à chaque occurrence de lien fonctionnel, le (ou les) chemin(s) topologique(s) qui la supportera.

La méthode d'aide à la réalisation de la plateforme avionique effectue certaines vérifications lors de l'opération d'association, ce qui permet de guider le choix des occurrences d'équipement et/ou de chemins topologiques.

Ainsi, pour associer un module logiciel à une occurrence d'équipement, on s'assure que cette occurrence d'équipement, par exemple un calculateur, dispose bien des quantités de ressources matérielles nécessaires à ce module. On entend ici par ressource matérielle une ressource matérielle dont a besoin un logiciel pour son stockage et/ou son exécution.

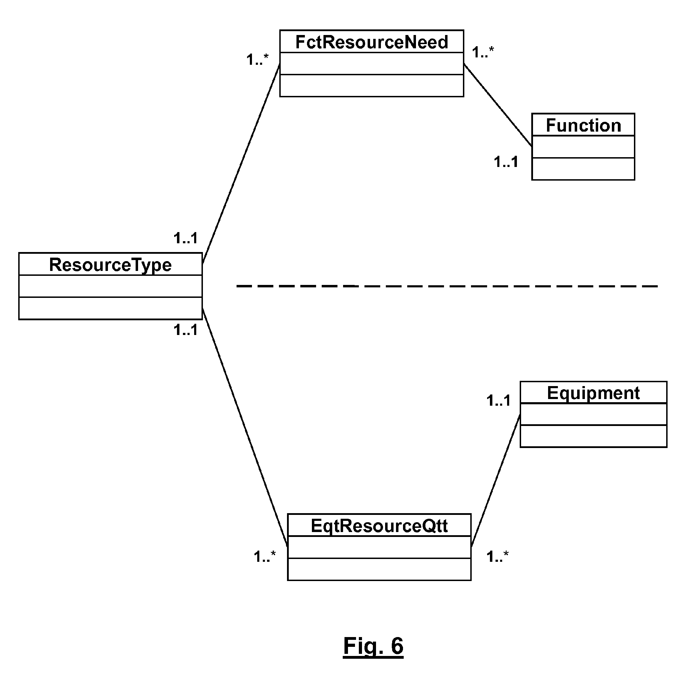

On a représenté en Fig. 6, un complément des représentations en Figs. 1 et 2, permettant de spécifier les besoins en ressources matérielles des différentes fonctions avioniques d'une part et les quantités de ressources matérielles offertes par les différents équipements, d'autre part.

Chaque objet « Function » est associé à un ou des besoin(s) en ressources matérielles « FctResourceNeed » de différents types qui sont nécessaires à l'exécution de la fonction, les types de ressources étant modélisés par l'objet « ResourceType ». Par exemple, on peut citer comme type de ressource, la puissance de calcul (nombre d'opérations élémentaires de calcul par unité de temps), la quantité de RAM, de ROM ou encore de disque dur, NVME (*Non Volatile MEmory*).

Les quantités de ressources matérielles nécessaires à une fonction dépendent de celles dont ont besoin les modules logiciel qui l'implémentent. Plus précisément, si l'on note $res(f_i, \alpha_j)$ la quantité de ressource matérielle $\alpha_j$ requise par la fonction avionique $f_i$ et, de manière similaire, $res(sm_k, \alpha_j)$ la quantité de ressource $\alpha_j$ requise par le module logiciel, on a :

$$res\left(sm_k, \alpha_j\right) = \sum_{f_i \in \Omega_k} res\left(f_i, \alpha_j\right) \tag{1}$$

où $\Omega_k$ est l'ensemble de fonctions avioniques associées au module logiciel $sm_k$ dans la base de données fonctionnelle.

De manière similaire, chaque objet « Equipment » dispose d'une certaine quantité des ressources matérielles en question ou de certaines d'entre elles seulement, cette quantité étant modélisée par l'objet « EqtResourceQtt ». Par exemple, un équipement pourra être caractérisé par sa puissance de calcul, sa taille de RAM, de ROM ou de NVME. On rappelle que chaque instance d'équipement « EquipmentOc » hérite des attributs de l'objet « Equipment » et donc sera caractérisé par les mêmes ressources matérielles.

Si l'occurrence d'équipement $m$ est destinée à héberger un ou plusieurs module(s) logiciel $sm_k$, il faudra vérifier que ses ressources matérielles permettent de pouvoir exécuter les modules en question, à savoir :

$$\beta_m\left(\alpha_j\right) \geq \sum_{k \in \Lambda_m} res\left(sm_k, \alpha_j\right) \tag{2}$$

où $\beta_m(\alpha_j)$ est la quantité de ressource matérielle $\alpha_j$ dont dispose l'occurrence d'équipement $m$ et $\Lambda_m$ est l'ensemble des modules logiciels destinés à être hébergés par celle-ci.

Selon une variante de réalisation de l'outil 500, pour un module logiciel donné, on pourra par exemple proposer une liste d'occurrences d'équipement de type donné (par exemple un calculateur) susceptible de l'héberger, en fonction de leurs ressources restantes respectives.

La méthode selon l'invention permet de s'assurer de la cohérence entre lien fonctionnel et chemin topologique au sens défini plus haut. Plus précisément, pour s'assurer qu'un chemin topologique est capable de transporter les messages du lien fonctionnel, on vérifie que le module logiciel émetteur des messages et le module logiciel destinataire de ces messages sont bien hébergés par des occurrences d'équipement (par exemple des calculateurs) et qu'il existe bien un chemin topologique reliant ces occurrences.

Selon une variante, l'outil 500 pourra proposer, pour un lien fonctionnel donné entre un premier et un second modules logiciel, l'ensemble des chemins topologiques possibles permettant de relier deux occurrences d'équipement hébergeant respectivement ces modules. On pourra alors sélectionner à l'aide de la station de travail 530, un chemin topologique parmi ceux proposés.

Lorsque tous les liens fonctionnels ont été associés à des chemins topologiques et tous les modules logiciel ont été associés à des occurrences d'équipement sur lesquels ils sont destinés à être hébergés, l'outil génère le fichier d'implémentation 550. La plateforme avionique est réalisée selon les associations spécifiées dans ce fichier, autrement dit les modules logiciel chargés dans les différents équipements (occurrences d'équipement) et les liaisons physiques de différents types sont réalisées pour les relier.

Préalablement à l'opération d'association précitée, l'outil 500 peut permettre d'aider à la génération, d'une part, des liaisons physiques, des liens et des chemins topologiques entre occurrences d'équipement et, d'autre part, des occurrences de lien fonctionnel entre modules logiciel associés à différentes fonctions avioniques.

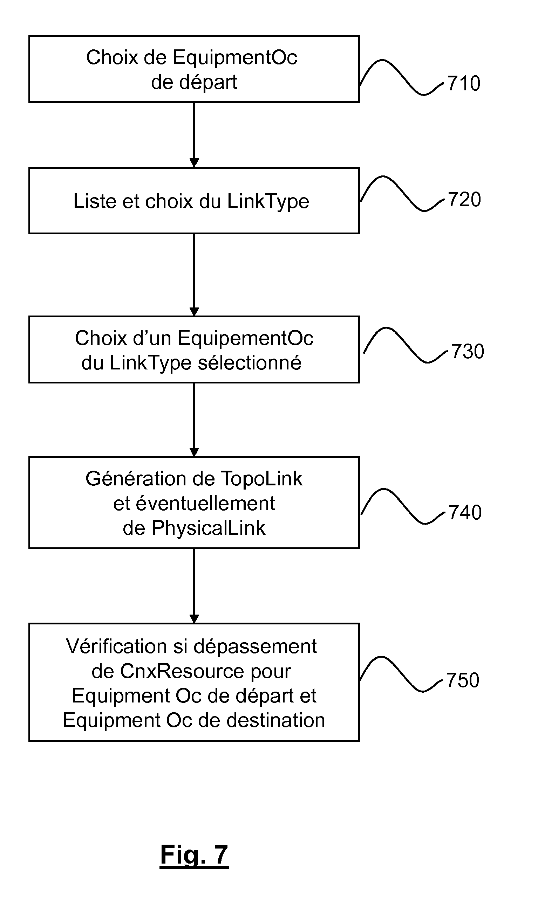

La génération des liens topologiques et, le cas échéant, des liaisons physiques sous-jacentes est effectuée en cinq étapes comme représenté en Fig. 7.

A l'étape 710, on choisit une occurrence d'équipement qui sera le départ du lien topologique.

A l'étape 720, l'outil 500 propose automatiquement l'ensemble des types de liaison supportés par l'équipement grâce à une ressource de communication « CnxResource » associée à l'un de ses connecteurs (cf. flèche (A) en Fig. 2). On sélectionne alors un type de liaison dans l'ensemble proposé.

A l'étape 730, l'outil 500 propose l'ensemble des occurrences d'équipement issues d'un équipement quelconque, associé au type sélectionné à travers une ressource de connexion d'un connecteur de cet équipement (cf. flèche (B) en Fig. 2). On sélectionne dans l'ensemble proposé une occurrence d'équipement qui sera la destination du chemin topologique.

A l'étape 740, on cherche à générer un lien topologique entre l'occurrence d'équipement de départ et l'occurrence d'équipement de destination.

Pour ce faire, on distingue en fonction du type de liaison sélectionné à l'étape 720 :

Si le type de liaison choisi est 1⇔1, l'outil propose de créer une nouvelle liaison physique du type choisi, autrement dit de créer un lien topologique bidirectionnel (cf. flèche (C) en Fig. 2) ou de manière équivalente deux liens topologiques orientés ;

Si le type de liaison choisi est $N{\Leftrightarrow}N$, l'outil propose soit de créer une nouvelle liaison physique du type choisi, soit d'associer le lien topologique à une liaison physique existante, du type choisi et reliant les deux occurrences d'équipement ;

Si le type de liaison choisi est 1⇒1, l'outil propose par défaut de créer une liaison physique du type choisi allant de l'occurrence de l'équipement de départ à l'occurrence d'élément de destination. Le cas échéant, l'outil peut proposer en outre de créer une seconde liaison physique dans l'autre sens. Dans le premier cas, le lien topologique est unidirectionnel (un seul lien topologique orienté) et dans le second cas, il est bidirectionnel (deux liens topologiques orientés) ;

Si le type de liaison choisi est 1⇒N, l'outil propose par défaut, soit de créer une liaison physique du type choisi dans le sens allant de l'occurrence de l'équipement de départ à l'occurrence d'élément de destination, soit d'associer le lien topologique à une liaison physique existante, du type choisi et reliant les deux occurrences d'équipement. Le cas échéant, l'outil peut en outre proposer de créer une seconde liaison physique du même type, dans l'autre sens, soit d'associer le lien topologique à une liaison physique existante de ce type, également dans l'autre sens, c'est-à-dire orientée de l'occurrence d'équipement de destination vers l'occurrence d'équipement de départ.

A l'étape 750, on vérifie qu'il existe des connecteurs au niveau des occurrences d'équipement de départ et de destination tels que les liaisons physiques éventuellement créées ne conduisent pas à dépasser les ressources de connexion associées à ces connecteurs pour le type de liaison choisi (attribut CnxNb dans l'objet « CnxResource »). S'il n'existe plus assez de ressources de connexion au niveau des connecteurs, soit du côté de l'occurrence d'équipement de départ, soit du côté de l'occurrence d'équipement de destination, la génération du lien topologique est invalidée. En revanche, si les ressources de connexion sont en quantité suffisante, on peut proposer automatiquement la liste des connecteurs pouvant accueillir le lien topologique.

L'outil 500 permet ainsi de générer des liens topologiques et des liaisons physiques sous jacentes entre occurrences d'équipement.

Une fois les liens topologiques créés, l'outil 500 peut générer automatiquement à partir de ces liens des chemins réseau entre noeuds de communication et les chemins topologiques entre occurrences d'équipement, dans le cas où ces chemins ne se réduisent pas à une simple liaison physique (cas de la Fig. 7 déjà décrit). Il convient de noter que la prise en compte de contraintes spécifiées dans le fichier 540 peut conduire à prescrire ou interdire certains chemins réseau (par exemple contraintes de ségrégation ou de collocation).

L'outil 500 permet également d'aider à la construction des liens fonctionnels entre modules logiciel associés à différentes fonctions avioniques. Pour un lien entre deux fonctions avioniques $f_i$ et $f_j$ données, la station de travail affiche une matrice de liens fonctionnel dont l'une des dimensions représente les modules logiciel associés à la fonction $f_i$ et l'autre dimension représente les modules logiciel associés à la fonction $f_j$. Par défaut, la matrice est pleine, autrement dit tous les liens fonctionnels possibles sont choisis. On peut alors éliminer certains de ces liens fonctionnels en les désélectionnant dans la matrice.

## Revendications

1. Méthode d'aide à la réalisation d'une plate-forme avionique, au moyen d'un outil comprenant une première base de données fonctionnelle dans laquelle est stockée une description fonctionnelle de ladite plate-forme, une seconde base de données matérielle dans laquelle est stockée une description matérielle de ladite plate-forme, et une station de travail, reliée aux première et seconde bases de données, ladite méthode étant destinée à implémenter un ensemble de fonctions avioniques, chaque fonction avionique (Function) comprenant un ou plusieurs modules logiciel (SystemFunctionOc), deux modules logiciel quelconques pouvant échanger des messages au moyen d'un lien (FctLinkOc), dit occurrence de lien fonctionnel, ladite plateforme avionique comprenant par ailleurs des équipements (EquipmentOc) reliés entre eux par des liaisons physiques (PhysicalLink) unidirectionnelles ou bidirectionnelles appartenant à différents types de réseau, des chemins (Path) permettant de relier lesdits équipements, chaque chemin étant constitué soit par une seule liaison physique directe entre un équipement source et un équipement destinataire, soit par une première liaison physique entre ledit équipement source et un premier noeud de réseau, une seconde liaison physique entre ledit équipement destinataire et un second noeud de réseau et au moins une troisième liaison physique entre lesdits premier et second noeuds (NetPath), **caractérisée en ce que** l'on associe à chaque module logiciel un équipement sur lequel il est destiné à être hébergé et à chaque occurrence de lien fonctionnel au moins un chemin destiné à faire transiter les messages de ce lien et, que l'on vérifie pour chaque équipement ($m$) s'il dispose de ressources matérielles ($\beta_m(\alpha_j)$) suffisantes pour permettre l'exécution du module ou des modules logiciel qui lui est (sont) associé(s).

2. Méthode d'aide à la réalisation d'une plateforme avionique selon la revendication 1, **caractérisée en ce que**, pour chaque équipement, l'on vérifie en outre si les ressources de connexion (CnxResource) de ses connecteurs sont suffisantes pour accueillir les chemins (Path) associés aux liens fonctionnels des modules logiciel qui lui sont associés.

3. Méthode d'aide à la réalisation d'une plateforme avionique selon la revendication 1, **caractérisée en ce que** les liaisons physiques peuvent être d'un premier type ($1 \Rightarrow 1$) permettant de relier de manière unidirectionnelle un équipement à un seul autre équipement, ou bien d'un second type ($1 \Rightarrow N$) permettant de relier de manière unidirectionnelle un équipement à une pluralité d'autres équipements, d'un troisième type ($1 \Leftrightarrow 1$) permettant de relier de manière bidirectionnelle deux équipements, ou encore d'un quatrième type ($N \Leftrightarrow N$) permettant de relier de manière bidirectionnelle une pluralité d'équipements.

4. Méthode d'aide à la réalisation d'une plateforme avionique selon la revendication 3, **caractérisée en ce qu'**à chaque connecteur d'un équipement sont associées des ressources de connexion (CnxResource), chaque ressource de connexion étant capable de recevoir une liaison physique (PhysicalLink) du premier, second, troisième ou bien quatrième type.

5. Méthode d'aide à la réalisation d'une plateforme avionique selon la revendication 4, **caractérisée en ce que**, pour chaque équipement source, on liste les types des liaisons physiques associées aux ressources de connexion des connecteurs de cet équipement, on sélectionne (720) un type de liaison parmi les types de liaisons ainsi listés, puis on liste les équipements possédant des ressources de connexion capables de recevoir le type de liaison ainsi sélectionné et l'on sélectionne (730) un équipement destinataire parmi les équipements ainsi listés.

**6.** Méthode d'aide à la réalisation d'une plateforme avionique selon la revendication 5, **caractérisée en ce que** l'on génère (740) un chemin entre l'équipement source et l'équipement destinataire en créant une nouvelle liaison physique du dit type sélectionné entre ces deux équipements, si celui-ci est le premier ou le troisième type, le chemin généré étant alors associé à la liaison physique ainsi créée et étant unidirectionnelle dans le cas du premier type et bidirectionnelle dans le cas du troisième type.

**7.** Méthode d'aide à la réalisation d'une plateforme avionique selon la revendication 5, **caractérisée en ce que** l'on génère (740) un chemin entre l'équipement source et l'équipement destinataire en l'associant à une liaison physique existante ou en créant une nouvelle liaison du dit type sélectionné entre ces deux équipements, si ledit type sélectionné est le deuxième ou le quatrième type, le chemin généré étant alors associé à la liaison existante ou créée et étant unidirectionnelle dans le cas du deuxième type et bidirectionnelle dans le cas du quatrième type.

**8.** Méthode d'aide à la réalisation d'une plateforme avionique selon la revendication 6 ou 7, **caractérisée en ce que** l'on vérifie (750) si les ressources de connexion des connecteurs de l'équipement source d'une part et celles des connecteurs de l'équipement destinataire, d'autre part, sont suffisantes pour accueillir les nouvelles liaisons physiques créées, le chemin généré étant validé dans l'affirmative et invalidé dans la négative.

**9.** Méthode d'aide à la réalisation d'une plateforme avionique selon l'une des revendications précédentes, **caractérisée en ce que** si les ressources matérielles et/ou les ressources de connexion sont suffisantes, on implémente ladite plateforme avionique à l'aide de ces ressources.

**10.** Outil d'aide à la réalisation d'une plateforme avionique, **caractérisé en ce qu'**il comprend une première base de données (510) dans laquelle est stockée une description fonctionnelle de ladite plate-forme, une seconde base de données (520) dans laquelle est stockée une description matérielle de ladite plate-forme, une station de travail (530) reliée aux première et seconde bases de données, ladite station de travail comprenant des moyens adaptés à mettre en oeuvre les étapes de la méthode selon l'une des revendications 1 à 8.

**11.** Outil d'aide à la réalisation d'une plateforme avionique selon la revendication 10, **caractérisé en ce que** la description fonctionnelle comprend une liste des fonctions avioniques et des liens entre elles, une liste des modules logiciel permettant d'exécuter les fonctions avioniques et des occurrences de lien fonctionnel entre ces modules, et que la description matérielle comprend une liste d'équipements de calcul ou de communication ainsi qu'une liste des liaisons physiques entre ces équipements.

**Fig. 1**

**Fig. 2**

**Fig. 3A**

$PL_2$

$Eq_2$

$Eq_1$

$PL_1$

$Eq_3$

**Fig. 3B**

$Eq_2$

$TL_1$

$Eq_1$

$TL_3$

$TL_2$

$Eq_3$

$P_{12}$

$Eq_1$ — $TL_1$ — $SW_1$ — $NP_{21}$ — $SW_2$ — $TL_3$ — $Eq_2$

$TL_2$

$NP_{12}$

$TL_4$

$P_{21}$

$P_{13}$

$NP_{13}$

$TL_5$

$NP_{23}$

$P_{23}$

$Eq_3$ — $TL_7$ — $SW_3$

$TL_6$ — $SW_4$

**Fig. 3C**

**Fig. 4**

500

510

520

530

540

550

**Fig. 5**

**Fig. 6**

```
┌─────────────────────────────┐
│   Choix de EquipmentOc      │         710
│      de départ              │╱╲    ╱
└─────────────────────────────┘  ╲╱
              │
              ▼
┌─────────────────────────────┐
│  Liste et choix du LinkType │╱╲    ╱720
└─────────────────────────────┘  ╲╱
              │
              ▼
┌─────────────────────────────┐
│   Choix d'un EquipementOc   │         730
│   du LinkType sélectionné   │╱╲    ╱
└─────────────────────────────┘  ╲╱
              │
              ▼
┌─────────────────────────────┐
│   Génération de TopoLink    │
│    et éventuellement        │╱╲    ╱740
│    de PhysicalLink          │  ╲╱
└─────────────────────────────┘
              │
              ▼
┌─────────────────────────────┐
│  Vérification si dépassement│
│     de CnxResource pour     │         750
│  Equipment Oc de départ et  │╱╲    ╱
│  Equipment Oc de destination│  ╲╱
└─────────────────────────────┘
```

**Fig. 7**

Europäisches
Patentamt

European
Patent Office

Office européen
des brevets

**RAPPORT DE RECHERCHE EUROPEENNE**

Numéro de la demande

EP 10 16 1728

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | DE 10 2005 055000 A1 (AIRBUS GMBH [DE]) 24 mai 2007 (2007-05-24) * le document en entier * * figure 1 * | 1-11 | INV. G06F17/50 G06F9/00 |
| X | EP 2 014 898 A2 (HONEYWELL INT INC [US]) 14 janvier 2009 (2009-01-14) * le document en entier * * figure 1a * | 1-11 | |
| X | US 2008/091300 A1 (FLETCHER MITCHELL S [US] ET AL) 17 avril 2008 (2008-04-17) * le document en entier * * figure 3 * | 1-11 | |
| X | EP 1 739 010 A1 (MESSIER BUGATTI [FR]) 3 janvier 2007 (2007-01-03) * figure 2a * * le document en entier * | 1-11 | |

DOMAINES TECHNIQUES RECHERCHES (IPC)

G06F

Le présent rapport a été établi pour toutes les revendications

| Lieu de la recherche | Date d'achèvement de la recherche | Examinateur |
|---|---|---|
| Munich | 23 juillet 2010 | Wellisch, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 10 16 1728

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-07-2010

| Document brevet cité au rapport de recherche | Date de publication | Membre(s) de la famille de brevet(s) | Date de publication |
|---|---|---|---|
| DE 102005055000 A1 | 24-05-2007 | CA 2627492 A1<br>CN 101310266 A<br>EP 1949248 A1<br>WO 2007057189 A1<br>JP 2009516275 T<br>US 2010153684 A1 | 24-05-2007<br>19-11-2008<br>30-07-2008<br>24-05-2007<br>16-04-2009<br>17-06-2010 |
| EP 2014898 A2 | 14-01-2009 | US 2009312892 A1 | 17-12-2009 |
| US 2008091300 A1 | 17-04-2008 | AUCUN | |
| EP 1739010 A1 | 03-01-2007 | BR PI0602357 A<br>CA 2550797 A1<br>CN 1891544 A<br>ES 2308694 T3<br>FR 2887516 A1<br>US 2006293805 A1 | 21-02-2007<br>27-12-2006<br>10-01-2007<br>01-12-2008<br>29-12-2006<br>28-12-2006 |

EPO FORM P0460

Pour tout renseignement concernant cette annexe : voir Journal Officiel de l'Office européen des brevets, No.12/82